(19) Europäisches Patentamt
European Patent Office
Office européen des brevets

(11) **EP 4 414 722 A1**

(12) **EUROPÄISCHE PATENTANMELDUNG**

(43) Veröffentlichungstag:
**14.08.2024 Patentblatt 2024/33**

(21) Anmeldenummer: **23218400.2**

(22) Anmeldetag: **20.12.2023**

(51) Internationale Patentklassifikation (IPC):
***G01R 22/06*** *(2006.01)*

(52) Gemeinsame Patentklassifikation (CPC):
**G01R 22/066; B60L 3/12; B60L 5/38;**
B60L 2200/36; B60L 2270/32; G01R 27/08;
G01R 27/16; G01R 31/005

(84) Benannte Vertragsstaaten:
**AL AT BE BG CH CY CZ DE DK EE ES FI FR GB
GR HR HU IE IS IT LI LT LU LV MC ME MK MT NL
NO PL PT RO RS SE SI SK SM TR**
Benannte Erstreckungsstaaten:
**BA**
Benannte Validierungsstaaten:
**KH MA MD TN**

(30) Priorität: **09.02.2023 DE 102023201048**

(71) Anmelder: **Siemens Mobility GmbH
81739 München (DE)**

(72) Erfinder: **Sänger, Göran
12587 Berlin (DE)**

(74) Vertreter: **Siemens Patent Attorneys
Postfach 22 16 34
80506 München (DE)**

(54) **MANIPULATIONSGESCHÜTZTE EINSPEISEENERGIEMESSUNG**

(57) Es wird eine Detektionseinrichtung (8) für eine Einspeiseenergiemesseinrichtung (10) beschrieben. Die Detektionseinrichtung (8) weist einen Messwiderstand ($R_{mess}$) auf, welcher in eine Einspeiseleitung der Einspeiseenergiemesseinrichtung (10) integriert ist. Teil der Detektionseinrichtung (8) ist auch eine Widerstandsmesseinrichtung (11), welche parallel zu dem Messwiderstand ($R_{mess}$) geschaltet ist, zum Messen eines elektrischen Widerstandswerts (R). Die Detektionseinrichtung (8) umfasst außerdem noch eine Schnittstelle (6b) zu einer Auswerteeinrichtung (6) zum Übermitteln des gemessenen elektrischen Widerstandswerts (R) an die Auswerteeinrichtung (6) zum Ermitteln einer Abweichung ($\Delta R$) des gemessenen elektrischen Widerstandswerts (R) von einem durch den Widerstandswert des Messwiderstands ($R_{mess}$) gebildeten Referenzwert. Es wird auch eine Einspeiseenergiemesseinrichtung (10) beschrieben. Weiterhin wird ein Fahrzeug (12) beschrieben. Überdies wird ein Verfahren zum Detektieren einer Manipulation einer Einspeiseenergiemesseinrichtung (10) beschrieben.

FIG 3

EP 4 414 722 A1

**Beschreibung**

Die Erfindung betrifft eine Detektionseinrichtung für eine Einspeiseenergiemesseinrichtung. Zudem betrifft die Erfindung eine Einspeiseenergiemesseinrichtung. Außerdem betrifft die Erfindung ein Fahrzeug. Ferner bezieht sich die Erfindung auch auf ein Verfahren zum Detektieren einer Manipulation einer Einspeiseenergiemesseinrichtung.

Der elektrische Betrieb von Fahrzeugen mit umfangreichen Nutzlasten über lange Strecken ist mit elektrischen Batterien bzw. Akkumulatoren allein kaum zu realisieren, da die Energiedichte von Batterien für die für diese Aufgabe benötigten Energiemengen auf absehbare Zeit zu gering bleiben wird.

Daher gibt es neben dem Transport solcher Lasten über die Schiene auch Konzepte, Fernstraßen mit elektrischen Stromnetzen mit Oberleitungen auszustatten und elektrisch betriebene Fahrzeuge, insbesondere Lastkraftwagen, extern über diese Oberleitungen mit elektrischer Energie zu versorgen. Ein solches Konzept wurde zum Beispiel in den eHighway-Projekten ELISA2 und FESH umgesetzt. Für eine korrekte Abrechnung des über die Oberleitungen bezogenen elektrischen Stroms weisen die elektrisch betriebenen Fahrzeuge Zähleinrichtungen bzw. Messschaltungen auf, mit denen der Stromverbrauch eines jeweiligen Fahrzeugs ermittelbar ist. Die Besonderheit einer solchen Messschaltung gegenüber ortsfesten Systemen besteht darin, dass es sich konstruktiv nicht oder nahezu nicht vermeiden lässt, dass Energieleiter frei zugängliche metallische Oberflächen aufweisen, die sich, was den Energiefluss betrifft, vor der Messstelle befinden. Als für die Abrechnung relevante Übergabestelle zwischen dem Energienetz und dem Abnehmer der Energie, also dem elektrisch betriebenen Fahrzeug, wird der Kontaktpunkt des Schleifstücks des Stromabnehmers des Fahrzeugs mit der Oberleitung des Stromversorgungsnetzes betrachtet. Das Schleifstück muss von außen frei zugängliche Kontaktstellen besitzen, um seine Kontaktfunktion zu erfüllen. In der Regel sind diese Schleifstücke frei von einer elektrischen Isolierung nicht nur an der vorgesehenen Kontaktfläche, sondern auch an vielen anderen Stellen.

Werden für Abrechnungszwecke geeignete und geeichte Energiemessgeräte eingesetzt, so ist ein Schutz vor unerlaubter Manipulation besonders wichtig, um eine Verfälschung des Messergebnisses und der Abrechnung der aus dem Stromnetz bezogenen elektrischen Energie zu verhindern. Eine solche Manipulation lässt sich relativ einfach realisieren, indem mit einem zusätzlichen elektrischen Leiter der Energiefluss durch die Strom-Zähleinrichtung an der Messstelle überbrückt wird, weil die erwähnten Kontaktstellen vor der Einspeisestelle der Strom-Zähleinrichtung zur Verfügung stehen und nach einer Entfernung einer Überbrückungseinrichtung keine bleibenden Spuren der Manipulation erkennbar wären.

Es besteht also die Aufgabe, eine Vorrichtung und ein Verfahren zu entwickeln, mit denen ein Manipulationsversuch bzw. eine Überbrückung einer Strom-Zähleinrichtung eines Fahrzeugs, das über ein Energieeinspeisenetz mit elektrischer Energie versorgt wird, detektierbar ist.

Diese Aufgabe wird durch eine Detektionseinrichtung für eine Einspeiseenergiemesseinrichtung gemäß Patentanspruch 1, eine Einspeiseenergiemesseinrichtung gemäß Patentanspruch 6, ein Fahrzeug gemäß Patentanspruch 11 und ein Verfahren zum Detektieren einer Manipulation einer Einspeiseenergiemesseinrichtung gemäß Patentanspruch 13 gelöst.

Die erfindungsgemäße Detektionseinrichtung für eine Einspeiseenergiemesseinrichtung, vorzugsweise für ein über ein Energieeinspeisenetz mit elektrischer Energie versorgtes Fahrzeug, umfasst einen elektrischen Messwiderstand, welcher in eine Einspeiseleitung der Einspeiseenergiemesseinrichtung integriert ist. Weiterhin umfasst die erfindungsgemäße Detektionseinrichtung eine Widerstandsmesseinrichtung, welche parallel zu dem Messwiderstand geschaltet ist, zum Messen eines elektrischen Widerstandswerts.

Der elektrische Widerstandswert kann anschaulich als Ersatzwiderstand einer Parallelschaltung des Messwiderstands mit einer Serienschaltung, welche einen elektrischen Widerstand einer zu detektierenden, auf die Manipulation zurückzuführenden Überbrückungsschaltung sowie einen elektrischen Widerstand einer in die Einspeiseleitung integrierten Strommesseinrichtung umfasst, verstanden werden.

Außerdem weist die erfindungsgemäße Detektionseinrichtung eine Schnittstelle zu einer Auswerteeinrichtung zum Übermitteln des gemessenen elektrischen Widerstandswerts an die Auswerteeinrichtung zum Ermitteln einer Abweichung des gemessenen elektrischen Widerstandswerts von einem durch den Widerstandswert des Messwiderstands gebildeten Referenzwert auf.

Eine Manipulation der Stromzählung würde nun dazu führen, dass ein von dem vorbekannten Referenzwert abweichender Widerstandswert als der erwähnte Ersatzwiderstand der Parallelschaltung gemessen wird. Dieser Effekt ergibt sich daraus, dass die Widerstandsmesseinrichtung in einem Messmodus einen Gesamtwiderstand bzw. Ersatzwiderstand einer Parallelschaltung des Messwiderstands mit einer Serienschaltung eines Widerstands einer manipulationsbasierten Überbrückungsschaltung und eines Widerstands der bereits erwähnten Strommesseinrichtung der Einspeiseenergiemesseinrichtung misst. Für den gemessenen Widerstandswert bzw. Gesamtwiderstand bzw. Ersatzwiderstand R ergibt sich:

$$R = (R_{mess}^{-1} + (R_{ext} + R_A)^{-1})^{-1}. \qquad (1)$$

Dabei ist R der tatsächlich gemessene Widerstandswert des Ersatzwiderstands, $R_{mess}$ der Messwiderstand, $R_{ext}$ der externe Widerstand der Überbrückungsschaltung und $R_A$ der Widerstand der Strommesseinrichtung der Einspeiseenergiemesseinrichtung.

Eine Abweichung $\Delta R = R - R_{mess}$ des tatsächlich gemessenen Widerstandswerts von dem Messwiderstand $R_{mess}$ ergibt sich zu:

$$\Delta R = R_{mess} - (R_{mess}^{-1} + (R_{ext} + R_A)^{-1})^{-1} = \frac{R_{mess}^2}{R_{mess} + R_{ext} + R_A}. \qquad (2)$$

Tritt keine Manipulation auf, so ist $R_{ext} \gg R_a$, $R_{mess}$. Damit ist $\Delta R = 0$ Ohm. Liegt eine Manipulation vor und ist $R_{ext}$ sehr klein bzw. $R_{ext} \ll R_a$, $R_{mess}$ bzw. weist $R_{mess}$ einen sehr kleinen Widerstandswert nahe dem Wert "0" bzw. 0 Ohm auf, so ist

$$\Delta R = \frac{R_{mess}^2}{R_{mess} + R_A}. \qquad (3)$$

Vorteilhaft kann durch die Überwachung des Messwiderstands $R_{mess}$ eine Überbrückung der Einspeiseenergiemesseinrichtung ermittelt werden und damit ein widerrechtlicher unentgeltlicher Bezug von elektrischer Energie aus einem elektrischen Stromnetz zumindest zunächst detektiert werden. Es soll an dieser Stelle erwähnt werden, dass die Detektionseinrichtung besonders einfach für eine Energieversorgung eines Fahrzeugs mit Gleichstrom geeignet ist, aber für den Fall, dass die Widerstandsmesseinrichtung der erfindungsgemäßen Detektionseinrichtung dazu eingerichtet ist, Wechselstromwiderstände bzw. komplexe Impedanzen zu messen, auch für den Betrieb eines elektrifizierten Fahrzeugs mit Wechselstrom genutzt werden kann.

Die erfindungsgemäße Einspeiseenergiemesseinrichtung weist eine Einspeiseleitung mit zwei Einspeiseanschlüssen und vorzugsweise zwei Verbraucheranschlüssen, eine Spannungsmesseinrichtung, welche zwischen die zwei Einspeiseanschlüsse geschaltet ist, eine Strommesseinrichtung, welche in die Einspeiseleitung integriert ist, und die erfindungsgemäße Detektionseinrichtung, welche ebenfalls in die Einspeiseleitung integriert ist, auf. Die "Einspeiseleitung" kann auch als Leitungssystem, welches zwei Einspeiseleitungen umfasst, die jeweils zwischen einen Einspeiseanschluss und einen Verbraucheranschluss geschaltet sind, aufgefasst werden. Insbesondere bei der Nutzung der Einspeiseenergiemesseinrichtung für Gleichstrombetrieb sind die beiden Einspeiseleitungen dazu eingerichtet, mit unterschiedlichen Netzleitungen verbunden zu werden, die unterschiedliche elektrische Potentiale aufweisen. Beispielsweise weist eine erste Netzleitung ein positives Potential auf und ist die zweite Netzleitung mit einem Erdpotential verbunden. Es soll an dieser Stelle angemerkt werden, dass die Nutzung der erfindungsgemäßen Einspeiseenergiemesseinrichtung und der vorstehend beschriebenen erfindungsgemäßen Detektionseinrichtung bevorzugt für den Gleichstrombetrieb eines elektrifizierten Fahrzeugs, insbesondere eines Straßenfahrzeugs mit einer Energieversorgung über Fahrleitungen, insbesondere Oberleitungen, konzipiert ist, aber auch für den Betrieb mit Wechselstrom geeignet ist.

Die erfindungsgemäße Detektionseinrichtung ist im Normalbetrieb, wenn durch die Einspeiseleitung ein Laststrom fließt, mit der Strommesseinrichtung in Serie geschaltet und diese Serie ist zwischen einen Einspeiseanschluss und einen Verbraucheranschluss geschaltet.

Weiterhin umfasst die erfindungsgemäße Einspeiseenergiemesseinrichtung eine Auswerteeinrichtung, welche dazu eingerichtet ist, auf Basis eines Spannungsmesswerts der Spannungsmesseinrichtung und eines Strommesswerts der Strommesseinrichtung eine Menge einer Einspeiseenergie zu ermitteln. Hierzu ist die Auswerteeinrichtung mit der Spannungsmesseinrichtung und der Strommesseinrichtung über eine jeweilige Schnittstelle bzw. eine Datenleitung elektrisch verbunden, um eine Menge der über die Einspeiseleitung gelieferten Einspeiseenergie zu messen.

Die Auswerteeinrichtung ist außerdem erfindungsgemäß dazu eingerichtet, eine Abweichung des gemessenen elektrischen Widerstandswerts von einem durch den Widerstandswert des Messwiderstands gebildeten Referenzwert zu ermitteln.

Hierzu ist die Auswerteeinrichtung auch mit der Detektionseinrichtung über deren Schnittstelle zum Ermitteln einer Abweichung des von der Detektionseinrichtung gemessenen elektrischen Widerstandswerts von einem Referenzwert elektrisch verbunden. Vorteilhaft kann auf Basis der ermittelten Abweichung ermittelt werden, ob eine manipulative Überbrückungsschaltung die erfindungsgemäße Einspeiseenergiemesseinrichtung widerrechtlich überbrückt.

Das erfindungsgemäße Fahrzeug weist einen Stromabnehmer, vorzugsweise einen Pantographen, zum Kontaktieren des elektrischen Energieeinspeisenetzes auf. Zudem umfasst das erfindungsgemäße Fahrzeug eine Traktionseinheit zum Antreiben des Fahrzeugs mit der über den Stromabnehmer aus dem Energieeinspeisenetz bezogenen elektrischen Energie. Außerdem weist das erfindungsgemäße Fahrzeug die erfindungsgemäße Detektionseinrichtung auf. Das erfindungsgemäße Fahrzeug teilt die Vorteile der erfindungsgemäßen Detektionseinrichtung.

Bei dem erfindungsgemäßen Verfahren zum Detektieren einer Manipulation erfolgt eine Messung eines elektrischen Widerstandswerts parallel zu einem Messwiderstand, welcher in eine Einspeiseleitung der Einspeiseenergiemesseinrichtung integriert ist.

Zudem wird der gemessene elektrische Widerstandswert an eine Auswerteeinrichtung der Einspeiseenergiemesseinrichtung übermittelt, zum Ermitteln einer Abweichung des gemessenen elektrischen Widerstandswerts von einem durch den Widerstandswert des Messwiderstands gebildeten Referenzwert.

Auf Basis der ermittelten Abweichung kann schließlich eine Manipulation der Einspeiseenergiemesseinrichtung durch eine Überbrückung erkannt werden.

Vorteilhaft kann durch die Messung des elektrischen Widerstandswerts eine Überbrückung der Einspeiseenergiemesseinrichtung ermittelt bzw. detektiert werden und damit ein widerrechtlicher unentgeltlicher Bezug von elektrischer Energie aus einem elektrischen Stromnetz verhindert werden.

Ein Teil der zuvor genannten Komponenten der erfindungsgemäßen Detektionseinrichtung und der erfindungsgemäßen Einspeiseenergiemesseinrichtung kann ganz oder teilweise in Form von Softwaremodulen in einem Prozessor eines entsprechenden Rechensystems realisiert werden, z.B. von einer Steuereinheit oder einem bereits vorhandenen Rechensystem eines Schienenfahrzeugs. Eine weitgehend softwaremäßige Realisierung hat den Vorteil, dass auch schon bisher verwendete Rechensysteme auf einfache Weise durch ein Software-Update nachgerüstet werden können, um auf die erfindungsgemäße Weise zu arbeiten. Insofern wird die Aufgabe auch durch ein entsprechendes Computerprogrammprodukt mit einem Computerprogramm gelöst, welches direkt in ein Rechensystem ladbar ist, mit Programmabschnitten, um den Teilschritt des erfindungsgemäßen Verfahrens zum Ermitteln einer Abweichung des gemessenen elektrischen Widerstandswerts von einem durch den Widerstandswert des Messwiderstands gebildeten Referenzwert auszuführen, wenn das Programm in dem Rechensystem ausgeführt wird. Ein solches Computerprogrammprodukt kann neben dem Computerprogramm gegebenenfalls zusätzliche Bestandteile, wie z. B. eine Dokumentation, und/oder zusätzliche Komponenten, auch Hardware-Komponenten, wie z.B. Hardware-Schlüssel (Dongles etc.) zur Nutzung der Software, umfassen.

Zum Transport zum Rechensystem und/oder zur Speicherung an oder in dem Rechensystem kann ein computerlesbares Medium, z.B. ein Memorystick, eine Festplatte oder ein sonstiger transportabler oder fest eingebauter Datenträger dienen, auf welchem die von einem Rechensystem einlesbaren und ausführbaren Programmabschnitte des Computerprogramms gespeichert sind. Das Rechensystem kann z.B. hierzu einen oder mehrere zusammenarbeitende Mikroprozessoren oder dergleichen aufweisen.

Die abhängigen Ansprüche sowie die nachfolgende Beschreibung enthalten jeweils besonders vorteilhafte Ausgestaltungen und Weiterbildungen der Erfindung. Dabei können insbesondere die Ansprüche einer Anspruchskategorie auch analog zu den abhängigen Ansprüchen einer anderen Anspruchskategorie und deren Beschreibungsteilen weitergebildet sein. Zudem können im Rahmen der Erfindung die verschiedenen Merkmale unterschiedlicher Ausführungsbeispiele und Ansprüche auch zu neuen Ausführungsbeispielen kombiniert werden.

Bevorzugt ist die erfindungsgemäße Detektionseinrichtung auch dazu eingerichtet, in einem von einem Einspeisenetz getrennten Zustand betrieben zu werden. Vorteilhaft kann eine Verfälschung der Messung des Messwiderstands durch den Einspeisestrom vermieden werden. Dadurch, dass der Messwiderstand $R_{mess}$ in diesem Fall nicht mit einer weiteren Fremdspannung als die, die die Widerstandsmesseinrichtung selbst erzeugt, beaufschlagt ist, kann man sehr einfach den Ersatzwiderstand $R = U_{mess}/I$ (I ist der durch den Widerstand $R_{mess}$ fließende Strom) ermitteln. Anderenfalls müsste die Widerstandsmesseinrichtung komplexer aufgebaut sein. Z.B. könnte man mittels einer Wechselspannungs-Widerstandsmessung den Messstrom vom Laststrom ausreichend diskriminieren.

Ganz besonders bevorzugt ist der Messwiderstand der erfindungsgemäßen Detektionseinrichtung in Abhängigkeit von der Höhe eines Einspeisestroms und einer maximalen Wärmeabgabeleistung dimensioniert. Vorteilhaft kann eine Verlustleistung der Detektionseinrichtung beschränkt werden, was zu einem günstigen Energieverbrauchsverhalten eines die erfindungsgemäße Detektionseinrichtung umfassenden Fahrzeugs beiträgt. Ein typischer Wert für einen tolerierbaren Verlust wäre zum Beispiel 5 Watt. Bei einem Einspeisestrom bzw. Nenn-Laststrom von 300 Ampere ergäbe sich beispielsweise ein Messwiderstand mit einem maximalen Widerstandswert von 0,06 mOhm.

Bevorzugt ist der Messwiderstand der erfindungsgemäßen Detektionseinrichtung in Abhängigkeit von einer Mindestsensitivität dimensioniert. Vorteilhaft ist der Messwiderstand der erfindungsgemäßen Detektionseinrichtung derart dimensioniert, dass Überbrückungsschaltungen, deren Widerstand einen gewissen Widerstandswert unterschreitet, detektiert werden. Um signifikant Strom umleiten zu können, muss die Überbrückungsschaltung einen Widerstand aufweisen, der zumindest in derselben Größenordnung liegt wie der Widerstand des überbrückten Stromzweigs oder sogar geringer ist. Vorteilhaft wird man also einerseits den Widerstandswert des Messwiderstands nicht zu groß wählen, um im Normalbetrieb der Einspeiseenergiemesseinrichtung nicht zu viel Verlustleistung zu erzeugen, aber andererseits auch ausreichend groß wählen, dass Überbrückungsschaltungen detektiert werden. Es muss an dieser Stelle erwähnt werden, dass eine Überbrückungsschaltung nur dann für den Manipulanten zufriedenstellend funktioniert, wenn ihr Widerstandswert im Bereich des Widerstandswerts der überbrückten Einspeiseenergiemesseinrichtung liegt oder besser noch deutlich kleiner als dieser ist, wobei sich der Widerstandswert der überbrückten Einspeiseenergiemesseinrichtung aus dem Messwiderstand und dem Widerstand der Strommesseinrichtung zusammensetzt.

In einer Ausgestaltung der erfindungsgemäßen Einspeiseenergiemesseinrichtung ist die Auswerteeinrichtung dazu eingerichtet, auf Basis einer ermittelten Abweichung des gemessenen elektrischen Widerstandswerts von dem Referenzwert zu ermitteln, ob eine Manipulation der Einspeiseenergiemesseinrichtung vorliegt, und gegebenenfalls eine Manipulationsmeldung auszugeben. Vorteilhaft wird ein Betreiber eines Fahrzeugs oder des Stromnetzes bzw. Energieeinspeisenetzes oder eine Ordnungsinstanz über eine Manipulation der Einspeiseenergiemesseinrichtung informiert und kann gegebenenfalls Gegenmaßnahmen ergreifen. Die Information über den Manipulationsversuch kann in einer gesicherten Datenspeichereinheit in der Einspeiseenergiemesseinrichtung oder in der Auswerteeinrichtung gespeichert werden und/oder über eine Datenübertragungseinrichtung an die erwähnten Kontrollinstanzen übermittelt werden.

In einer Ausgestaltung der erfindungsgemäßen Einspeiseenergiemesseinrichtung ist die Auswerteeinrichtung dazu eingerichtet, auf Basis eines von der Strommesseinrichtung gemessenen Strommesswerts einen laststromfreien Zustand für eine Messung eines elektrischen Widerstandswerts des Messwiderstands zu ermitteln. Weiterhin ist die erfindungsgemäße Einspeiseenergiemesseinrichtung dazu eingerichtet, die Widerstandsmesseinrichtung der Detektionseinrichtung zum Messen eines elektrischen Widerstandwerts zu aktivieren, für den Fall, dass ein laststromfreier Zustand ermittelt wurde. Vorteilhaft kann durch die Detektion eines solchen laststromfreien Zustands für eine korrekte Messung des Messwiderstands gesorgt werden.

Die Einspeiseleitung der erfindungsgemäßen Einspeiseenergiemesseinrichtung weist vorzugsweise neben den beiden Einspeiseanschlüssen auch zwei verbraucherseitige Anschlüsse auf. Die Einspeiseanschlüsse und die Verbraucheranschlüsse sind nun vorteilhaft gegen eine unbefugte Trennung von der Einspeiseenergiemesseinrichtung durch eine Sicherungseinheit geschützt, um ein Umgehen der Einspeiseenergiemesseinrichtung durch eine Trennung der Anschlüsse von der Einspeiseenergiemesseinrichtung zu verhindern. Würden die Anschlüsse, beispielsweise durch Abschrauben geöffnet, so wäre bei einer Überbrückung der Einspeiseenergiemesseinrichtung die gesamte Strommessung und Überwachung durch die Einspeiseenergiemesseinrichtung blockiert und eine Manipulation könnte nicht mehr nachgewiesen werden. Vorteilhaft sind nun die erwähnten Anschlüsse gegen eine solche Manipulation gesichert.

Hierfür umfasst die Sicherungseinheit bevorzugt eine PlombenSicherung. Eine solche Plombensicherung verhindert zumindest die Nichtentdeckung einer Manipulation bzw. das unentdeckte Abschrauben der erwähnten Anschlüsse und trägt somit dazu bei, ein Abkoppeln der erfindungsgemäßen Einspeiseenergiemesseinrichtung und deren Blockierung zu verhindern.

Das erfindungsgemäße Fahrzeug ist bevorzugt als Straßenfahrzeug ausgebildet. Straßenfahrzeuge sind in der Regel individuellen Personen oder Unternehmen zugeordnet, die den Bezug von elektrischem Strom aus einem Energieeinspeisenetz in der Regel auch individuell abrechnen. Bei derartigen Fahrzeugen ist es besonders wichtig, dass die Abrechnung korrekt und ohne Betrug abläuft, um die eingespeisten Energiemengen auch korrekt abrechnen und zuordnen zu können.

Ebenfalls bevorzugt ist das erfindungsgemäße Fahrzeug als Schienenfahrzeug ausgebildet. Auch Schienenfahrzeuge können unterschiedlichen Betreibern gehören, die in unterschiedlichen Netzen unterwegs sind. Daher muss auch bei Schienenfahrzeugen eine korrekte Zuordnung des individuellen Energieverbrauchs zu einzelnen Schienenfahrzeugen und entsprechenden Netzbetreibern korrekt erfolgen. Es ist aber nochmals darauf hinzuweisen, dass das erfindungsgemäße Fahrzeug besonders bevorzugt ein Straßenfahrzeug umfasst, das aus einem Energieeinspeisenetz elektrische Energie bezieht.

Die Erfindung wird im Folgenden unter Hinweis auf die beigefügten Figuren anhand von Ausführungsbeispielen noch einmal näher erläutert. Es zeigen:

FIG 1 eine schematische Darstellung einer herkömmlichen Einspeiseenergiemesseinrichtung,

FIG 2 eine schematische Darstellung einer Einspeiseenergiemesseinrichtung gemäß einem Ausführungsbeispiel der Erfindung,

FIG 3 eine schematische Darstellung einer Detektionseinrichtung gemäß einem Ausführungsbeispiel der Erfindung,

FIG 4 ein Flussdiagramm, welches ein Verfahren zum Detektieren einer Manipulation einer Einspeiseenergiemesseinrichtung gemäß einem Ausführungsbeispiel der Erfindung veranschaulicht,

FIG 5 eine schematische Darstellung eines Fahrzeugs gemäß einem Ausführungsbeispiel der Erfindung.

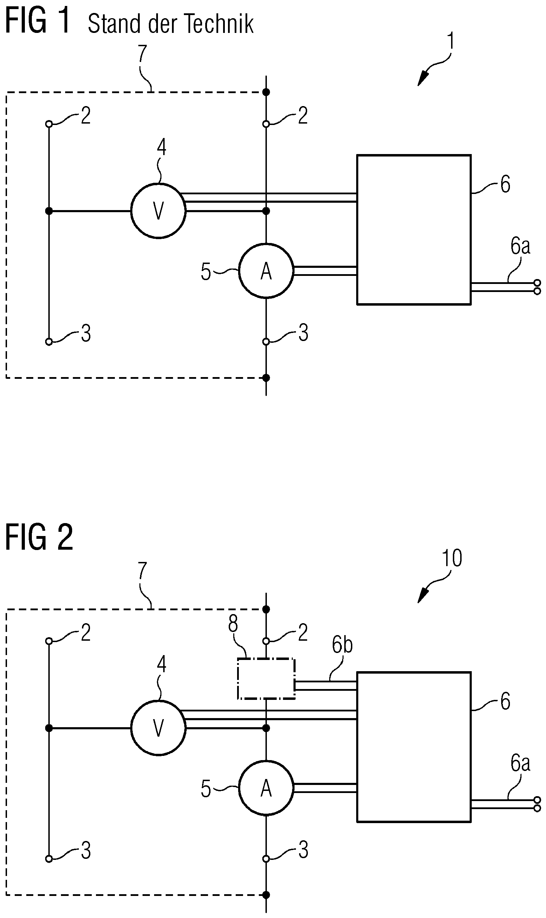

In FIG 1 ist eine herkömmliche Einspeiseenergiemesseinrichtung 1 eines Fahrzeugs schematisch dargestellt. Die Einspeiseenergiemesseinrichtung 1 weist eine Spannungsmesseinrichtung 4 auf, welche zwischen zwei Einspeiseanschlüsse 2 geschaltet ist. Teil der herkömmlichen Einspeiseenergiemesseinrichtung 1 ist auch eine Strommesseinrichtung 5, welche zwischen einen Einspeiseanschluss 2 und einen Verbraucheranschluss 3 geschaltet ist. Die herkömmliche Einspeiseenergiemesseinrichtung 1 umfasst außerdem eine Auswerteeinrichtung 6, welche mit der Spannungsmesseinrichtung 4 und der Strommesseinrichtung 5 elektrisch verbunden ist, um die Menge der über die Einspeiseanschlüsse 2 zugeführten Einspeiseenergie zu messen. Die Auswerteeinrichtung 6 weist außerdem einen externen Datenanschluss 6a auf. In FIG 1 ist im linken Teilbereich der Zeichnung auch eine Überbrückung 7 bzw. eine Überbrückungsleitung (gestrichelt gezeichnet) der herkömmlichen Einspeiseenergiemesseinrichtung 1 dargestellt.

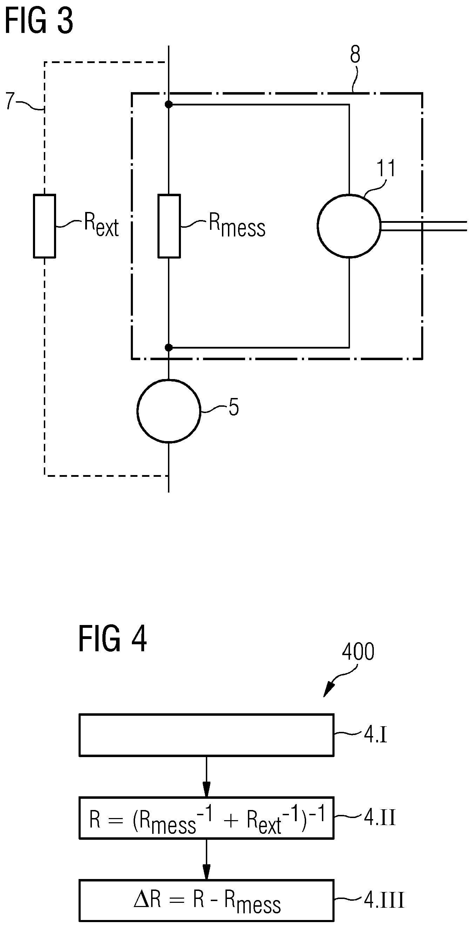

In FIG 2 ist eine schematische Darstellung einer Einspeiseenergiemesseinrichtung 10 gemäß einem Ausführungsbeispiel der Erfindung dargestellt. Die in FIG 2 dargestellte Einspeiseenergiemesseinrichtung 10 weist zusätzlich zu den bereits im Zusammenhang mit FIG 1 beschriebenen Komponenten 2, 3, 4, 5, 6, 6a eine Detektionseinrichtung 8 auf, die einen in FIG 3 dargestellten Aufbau hat. Außerdem umfasst die in FIG 2 dargestellte Einspeiseenergiemesseinrichtung 10 eine zusätzliche Schnittstelle 6b zwischen der Detektionseinrichtung 8 und der Auswerteeinrichtung 6. Über die zusätzliche Schnittstelle 6b werden Messergebnisse der Detektionseinrichtung 8 an die Auswerteeinrichtung 6 übertragen. Die Auswerteeinrichtung 6 ermittelt auf der Basis eines gemessenen Widerstandswerts R und eines Referenzwerts, welcher dem tatsächlichen Widerstandswert eines Messwiderstands $R_{mess}$ (siehe FIG 3) der Detektionseinrichtung 8 entspricht, ob eine Manipulation der Einspeiseenergiemesseinrichtung 10 durch eine Überbrückung 7 (in FIG 2 gestrichelt eingezeichnet) der Einspeiseenergiemesseinrichtung 10 vorliegt.

In FIG 3 ist eine Detektionseinrichtung 8 gemäß einem Ausführungsbeispiel der Erfindung schematisch dargestellt. Wie bereits erwähnt, umfasst die Detektionseinrichtung 8 einen Messwiderstand $R_{mess}$, der seriell zu der Strommesseinrichtung 5 und zwischen die genannte Strommesseinrichtung 5 und eine Einspeiseschnittstelle (nicht gezeigt), beispielsweise ein Schleifstück eines Pantographen, geschaltet ist. Die in FIG 3 gezeigte Detektionseinrichtung 8 weist weiterhin eine Widerstandsmesseinrichtung 11, auch als "Ohmmeter" bezeichnet, auf, mit der ein Ersatzwiderstand R einer Parallelschaltung des Messwiderstands $R_{mess}$ der Detektionseinrichtung 8 mit einer Serienschaltung des Widerstands $R_{ext}$ der Überbrückung 7 und des Widerstands $R_A$ der Strommesseinrichtung 5 ermittelt wird. Liegt eine Überbrückung vor, so weicht der Widerstandswert des gemessenen Ersatzwiderstands R von dem tatsächlichen Wert des als Referenzwiderstand genutzten Messwiderstands $R_{mess}$ ab und es kann daraus geschlossenen werden, dass eine Manipulation vorliegt.

In FIG 4 ist ein Flussdiagramm 400 gezeigt, welches ein Verfahren zum Detektieren einer Manipulation einer Einspeiseenergiemesseinrichtung 10 gemäß einem Ausführungsbeispiel der Erfindung veranschaulicht.

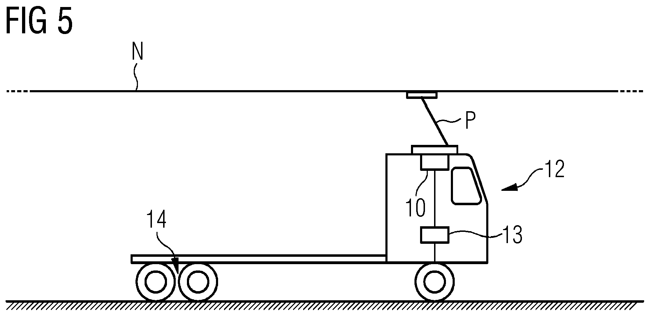

Bei dem Schritt 4.I wird eine Einspeiseenergiemesseinrichtung 10 eines elektrifizierten Fahrzeugs (siehe FIG 5), die den in FIG 2 gezeigten Aufbau hat, sowohl von einem Einspeisenetz N als auch von der Lastseite elektrisch getrennt und damit in einen Testzustand versetzt.

Bei dem Schritt 4.II wird ein elektrischer Widerstandswert eines Ersatzwiderstands R, welcher durch eine Parallelschaltung eines Messwiderstands $R_{mess}$ einer Detektionseinrichtung 8 der Einspeiseenergiemesseinrichtung 10 mit einer Serienschaltung aus einem Widerstand $R_{ext}$ einer möglichen Überbrückung 7 der Einspeiseenergiemesseinrichtung 10 und einem Widerstand $R_A$ einer Strommesseinrichtung 5 der Einspeiseenergiemesseinrichtung 10 gebildet wird, gemessen.

Bei dem Schritt 4.III wird eine Abweichung $\Delta R$ des gemessenen elektrischen Widerstandswerts des Ersatzwiderstands R von einem durch den Widerstandswert des Messwiderstands $R_{mess}$ gebildeten Referenzwert ermittelt.

In FIG 5 ist eine schematische Darstellung eines Fahrzeugs 12 gemäß einem Ausführungsbeispiel der Erfindung gezeigt. Das Fahrzeug 12, in diesem Fall ein LKW, weist einen Pantographen P auf, mit dem es ein Einspeisenetz N kontaktiert. Weiterhin umfasst das Fahrzeug 12 die erfindungsgemäße Einspeiseenergiemesseinrichtung 10 und einen Umrichter 13, mit dem der aus dem Einspeisenetz N bezogene Gleichstrom für Traktionseinheiten 14, die ebenfalls Teil des Fahrzeugs 12 sind, umgewandelt wird.

Es wird abschließend noch einmal darauf hingewiesen, dass es sich bei den vorbeschriebenen Verfahren und Vorrichtungen lediglich um bevorzugte Ausführungsbeispiele der Erfindung handelt und dass die Erfindung vom Fachmann variiert werden kann, ohne den Bereich der Erfindung zu verlassen, soweit er durch die Ansprüche vorgegeben ist. Es wird der Vollständigkeit halber auch darauf hingewiesen, dass die Verwendung der unbestimmten Artikel "ein" bzw. "eine" nicht ausschließt, dass die betreffenden Merkmale auch mehrfach vorhanden sein können. Ebenso schließt der Begriff "Einheit" nicht aus, dass diese aus mehreren Komponenten besteht, die gegebenenfalls auch räumlich verteilt sein können. Unabhängig vom grammatikalischen Geschlecht eines bestimmten Begriffes sind Personen mit männlicher, weiblicher oder anderer Geschlechteridentität mit umfasst.

**Patentansprüche**

1. Detektionseinrichtung (8) für eine Einspeiseenergiemesseinrichtung (10), aufweisend:

 - einen Messwiderstand ($R_{mess}$), welcher in eine Einspeiseleitung der Einspeiseenergiemesseinrichtung (10) integriert ist,

- eine Widerstandsmesseinrichtung (11), welche parallel zu dem Messwiderstand ($R_{mess}$) geschaltet ist, zum Messen eines elektrischen Widerstandswerts (R),
- eine Schnittstelle (6b) zu einer Auswerteeinrichtung (6) zum Übermitteln des gemessenen elektrischen Widerstandswerts (R) an die Auswerteeinrichtung (6) zum Ermitteln einer Abweichung ($\Delta R$) des gemessenen elektrischen Widerstandswerts (R) von einem durch den Widerstandswert des Messwiderstands ($R_{mess}$) gebildeten Referenzwert.

2. Detektionseinrichtung nach Anspruch 1, welche dazu eingerichtet ist, in einem von einem Einspeisenetz (N) getrennten, lastromfreien Zustand betrieben zu werden.

3. Detektionseinrichtung nach Anspruch 2, wobei der Messwiderstand ($R_{mess}$) in dem von einem Einspeisenetz (N) getrennten, lastromfreien Zustand parallel zu einer Serienschaltung aus einer möglicherweise vorhandenen Überbrückungsschaltung (7) und einer in der Einspeiseleitung der Einspeiseenergiemesseinrichtung (10) vorhandenen Strommesseinrichtung (5) geschaltet ist.

4. Detektionseinrichtung nach einem der vorstehenden Ansprüche, wobei der Messwiderstand ($R_{mess}$) in Abhängigkeit von der Höhe eines Einspeisestroms und einer maximalen Wärmeabgabeleistung dimensioniert ist.

5. Detektionseinrichtung nach einem der vorstehenden Ansprüche, wobei der Messwiderstand ($R_{mess}$) in Abhängigkeit von einer Mindestsensitivität dimensioniert ist.

6. Einspeiseenergiemesseinrichtung (10), aufweisend:

   - eine Einspeiseleitung mit zwei Einspeiseanschlüssen (2),
   - eine Spannungsmesseinrichtung (4) zwischen den beiden Einspeiseanschlüssen (2),
   - eine Strommesseinrichtung (5), welche in die Einspeiseleitung integriert ist,
   - eine Detektionseinrichtung (8) nach einem der Ansprüche 1 bis 5, welche ebenfalls in die Einspeiseleitung integriert ist,
   - eine Auswerteeinrichtung (6), welche dazu eingerichtet ist,

     - auf Basis eines Spannungsmesswerts der Spannungsmesseinrichtung (4) und eines Strommesswerts der Strommesseinrichtung (5) eine Menge einer Einspeiseenergie zu ermitteln, und
     - eine Abweichung ($\Delta R$) des gemessenen elektrischen Widerstandswerts (R) von einem durch den Widerstandswert des Messwiderstands ($R_{mess}$) gebildeten Referenzwert zu ermitteln.

7. Einspeiseenergiemesseinrichtung nach Anspruch 6, wobei die Auswerteeinrichtung (6) dazu eingerichtet ist, auf Basis der ermittelten Abweichung ($\Delta R$) des gemessenen elektrischen Widerstandswerts (R) von dem Referenzwert zu ermitteln, ob eine Manipulation der Einspeiseenergiemesseinrichtung (10) vorliegt und gegebenenfalls eine Manipulationsmeldung auszugeben.

8. Einspeiseenergiemesseinrichtung nach Anspruch 6 oder 7, wobei die Auswerteeinrichtung (6) dazu eingerichtet ist,

   - auf Basis eines von der Strommesseinrichtung (5) gemessenen Strommesswerts einen laststromfreien Zustand für eine Detektion einer möglichen Manipulation der Einspeiseenergiemesseinrichtung (10) zu ermitteln,
   - die Widerstandsmesseinrichtung (11) der Detektionseinrichtung (8) zum Messen eines elektrischen Widerstandswerts (R) zu aktivieren, für den Fall, dass ein laststromfreier Zustand ermittelt wurde.

9. Einspeiseenergiemesseinrichtung nach einem der Ansprüche 6 bis 8, wobei die Einspeiseleitung zwei Verbraucheranschlüsse (3) umfasst und die Einspeiseanschlüsse (2) und die Verbraucheranschlüsse (3) gegen eine unbefugte Trennung von der Einspeiseenergiemesseinrichtung (10) durch eine Sicherungseinheit geschützt sind.

10. Einspeiseenergiemesseinrichtung nach Anspruch 9, wobei die Sicherungseinheit eine Plombensicherung umfasst.

11. Fahrzeug (12), aufweisend:

    - einen Stromabnehmer (P) zum Kontaktieren eines elektrischen Energieeinspeisenetzes (N),
    - eine Traktionseinheit (14) zum Antreiben des Fahrzeugs (12) mit der über den Stromabnehmer (P) aus dem Energieeinspeisenetz (N) bezogenen elektrischen Energie und

- eine Detektionseinrichtung (8) nach einem der Ansprüche 1 bis 5.

**12.** Fahrzeug nach Anspruch 11, umfassend einen der folgenden Fahrzeugtypen:

- ein Straßenfahrzeug,
- ein Schienenfahrzeug.

**13.** Verfahren zum Detektieren einer Manipulation einer Einspeiseenergiemesseinrichtung (10), aufweisend die Schritte:

- Messen eines Widerstandswerts (R) parallel zu einem Messwiderstand ($R_{mess}$), welcher in eine Einspeiseleitung der Einspeiseenergiemesseinrichtung (10) integriert ist,
- Übermitteln des gemessenen elektrischen Widerstandswerts (R) an eine Auswerteeinrichtung (6) der Einspeiseenergiemesseinrichtung (10) zum Ermitteln einer Abweichung ($\Delta R$) des gemessenen elektrischen Widerstandswerts (R) von einem durch den Widerstandswert des Messwiderstands ($R_{mess}$) gebildeten Referenzwert.

**14.** Computerprogrammprodukt, umfassend Befehle, die bei der Ausführung des Programms durch einen Computer diesen veranlassen, den Teilschritt zum Ermitteln einer Abweichung ($\Delta R$) des gemessenen elektrischen Widerstandswerts (R) von einem Referenzwert ($R_{mess}$) des Verfahrens zum Detektieren einer Manipulation einer Einspeiseenergiemesseinrichtung (10) nach Anspruch 13 auszuführen.

**15.** Computerlesbares Speichermedium, umfassend Befehle, die bei der Ausführung durch einen Computer diesen veranlassen, den Teilschritt zum Ermitteln einer Abweichung ($\Delta R$) des gemessenen elektrischen Widerstandswerts (R) von einem Referenzwert ($R_{mess}$) des Verfahrens zum Detektieren einer Manipulation einer Einspeiseenergiemesseinrichtung (10) nach Anspruch 13 auszuführen.

# FIG 1 Stand der Technik

# FIG 2

# FIG 3

# FIG 4

4.I

$$R = (R_{mess}^{-1} + R_{ext}^{-1})^{-1}$$  4.II

$$\Delta R = R - R_{mess}$$  4.III

FIG 5

Europäisches Patentamt
European Patent Office
Office européen des brevets

# EUROPÄISCHER RECHERCHENBERICHT

**Nummer der Anmeldung**

EP 23 21 8400

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2014/253102 A1 (WOOD STEPHEN JAMES MARTIN [GB] ET AL) 11. September 2014 (2014-09-11) | 1-5, 13-15 | INV. G01R22/06 |
| Y | * Abbildung 2 * | 6-12 | |
| | - - - - - | | |
| Y | DE 10 2021 205686 A1 (SIEMENS MOBILITY GMBH [DE]) 8. Dezember 2022 (2022-12-08) * Abbildungen 1-3 * | 6-12 | |
| | - - - - - | | |
| A | US 2013/113507 A1 (DANESH SEYED AMIR ALI [GB] ET AL) 9. Mai 2013 (2013-05-09) * Abbildungen 1-3 * | 1-15 | |
| | - - - - - | | |
| A | EP 1 947 465 A2 (FAIVELEY TRANSPORT [FR]) 23. Juli 2008 (2008-07-23) * Abbildung 2 * | 1-15 | |
| | - - - - - | | |
| A | DE 10 2018 208152 A1 (SIEMENS MOBILITY GMBH [DE]) 28. November 2019 (2019-11-28) * Abbildung 1 * | 1-15 | |
| | - - - - - | | |

**RECHERCHIERTE SACHGEBIETE (IPC)**

G01R
B60L

Der vorliegende Recherchenbericht wurde für alle Patentansprüche erstellt

| Recherchenort | Abschlußdatum der Recherche | Prüfer |
|---|---|---|
| München | 31. Mai 2024 | Schindler, Martin |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
................................................................
& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 23 21 8400

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

31-05-2024

| Im Recherchenbericht angeführtes Patentdokument | Datum der Veröffentlichung | Mitglied(er) der Patentfamilie | Datum der Veröffentlichung |
|---|---|---|---|
| US 2014253102 A1 | 11-09-2014 | EP 2756318 A2 | 23-07-2014 |
| | | EP 3441775 A2 | 13-02-2019 |
| | | EP 3736578 A2 | 11-11-2020 |
| | | US 2014253102 A1 | 11-09-2014 |
| | | US 2016291060 A1 | 06-10-2016 |
| | | US 2018252748 A1 | 06-09-2018 |
| | | WO 2013038176 A2 | 21-03-2013 |
| DE 102021205686 A1 | 08-12-2022 | CN 117396353 A | 12-01-2024 |
| | | DE 102021205686 A1 | 08-12-2022 |
| | | EP 4320005 A1 | 14-02-2024 |
| | | WO 2022253881 A1 | 08-12-2022 |
| US 2013113507 A1 | 09-05-2013 | CN 104871012 A | 26-08-2015 |
| | | CN 108802462 A | 13-11-2018 |
| | | EP 2917744 A2 | 16-09-2015 |
| | | US 2013113507 A1 | 09-05-2013 |
| | | WO 2014072733 A2 | 15-05-2014 |
| EP 1947465 A2 | 23-07-2008 | AT E547714 T1 | 15-03-2012 |
| | | AT E557283 T1 | 15-05-2012 |
| | | EP 1947465 A2 | 23-07-2008 |
| | | EP 2295994 A1 | 16-03-2011 |
| | | ES 2383219 T3 | 19-06-2012 |
| | | ES 2385453 T3 | 25-07-2012 |
| | | FR 2911541 A1 | 25-07-2008 |
| | | PL 2295994 T3 | 31-10-2012 |
| DE 102018208152 A1 | 28-11-2019 | KEINE | |

EPO FORM P0461

Für nähere Einzelheiten zu diesem Anhang : siehe Amtsblatt des Europäischen Patentamts, Nr.12/82